# EUROPEAN PATENT APPLICATION

(11) **EP 4 779 822 A2**
(43) Date of publication of application: **22.07.2026**
(21) Application number: 25225360.4
(22) Date of filing: 19.12.2025
(51) Int. Cl.: H01S 5/06, H01S 5/0687, H01S 5/10, H01S 5/14, H01S 5/028, H01S 5/40, H01S 5/50

(54) **ULTRA-BROADBAND LASER**

(30) Priority: 31.12.2024 US 202419007101
(71) Applicant: Cisco Technology, Inc., San Jose, CA 95134-1706 (US)
(72) Inventor: Huang, Xue, San Jose (US); Chen, Long, San Jose, 95134-1706 (US); Givehchi, Mehrdad, San Jose, 95134-1706 (US)
(74) Representative: Noble, Nicholas

(57) **Abstract**

A tunable laser comprising at least two gain chips configured to generate light and a wavelength selection circuit. The wavelength selection circuit comprising a first waveguide coupled to a first gain chip of the at least two gain chips, a second waveguide coupled to a second gain chip of the at least two gain chips, a first wavelength selective photonic ring resonator optically coupled to the first waveguide, a second wavelength selective photonic ring resonator optically coupled to second waveguide, a third waveguide optically coupled to the first wavelength selective photonic ring resonator and the second wavelength selective photonic ring resonator; and a control circuit. The control circuit is configured to apply a first current to the first gain chip to bias the first gain chip, tune the first wavelength selective photonic ring resonator to a target wavelength, and tune the second wavelength selective ring resonator off-resonance.

## Description

### FIELD

This disclosure relates generally to tunable lasers.

### BACKGROUND

A conventional gain chip has a limited gain bandwidth between different wavelength bands. The gain of the gain chip will shift with temperature as well.

### BRIEF DESCRIPTION OF THE FIGURES

Unless specified otherwise, the accompanying drawings illustrate aspects of the innovations described herein. Referring to the drawings, wherein like numerals refer to like parts throughout the several views and this specification, several embodiments of presently disclosed principles are illustrated by way of example, and not by way of limitation. The drawings are not intended to be to scale. A more complete understanding of the disclosure may be realized by reference to the accompanying drawings in which:
Figure 1 illustrates a block diagram of a laser configuration, according to an embodiment of the present disclosure.
Figure 2 is an example of a tunable laser configuration, according to an embodiment of the present disclosure.
Figure 3 is an example laser configuration, according to an embodiment of the present disclosure.
Figure 4 illustrates the gain spectrum of the first gain chip and the second gain chip at different temperatures and wavelengths, according to an embodiment of the present disclosure.
Figure 5 is a general block diagram of a tunable laser to output laser power from the external cavity side, according to an embodiment of the present disclosure.
Figure 6 is a tunable laser configuration, according to an embodiment of the present disclosure.
Figure 7 is a fourth example of the proposed laser configuration, in which the laser output is at the PIC, according to an embodiment of the present disclosure.

### DESCRIPTION OF EXAMPLE EMBODIMENTS

### OVERVIEW

In part, in one aspect, the disclosure relates to a tunable laser comprising at least two gain chips configured to generate light and a wavelength selection circuit. Any of the at least two gain chips are configured to output the light generated by the tunable laser. The wavelength selection circuit comprising a first waveguide coupled to a first gain chip of the at least two gain chips, a second waveguide coupled to a second gain chip of the at least two gain chips, a first wavelength selective photonic ring resonator optically coupled to the first waveguide, a second wavelength selective photonic ring resonator optically coupled to second waveguide, a third waveguide optically coupled to the first wavelength selective photonic ring resonator and the second wavelength selective photonic ring resonator, and a control circuit. The control circuit configured to apply a first current to the first gain chip to bias the first gain chip, wherein biasing the first gain chip to output the light in a first wavelength band, tune the first wavelength selective photonic ring resonator to a target wavelength, and tune the second wavelength selective ring resonator off-resonance.

In part, in one aspect, the disclosure relates to a tunable laser comprising: at least two gain chips configured to generate light, wherein a first gain chip of the at least two gain chips is configured to output the light generated by the tunable laser and a wavelength selection circuit. The wavelength selection circuit comprising a first waveguide coupled to the first gain chip, a second waveguide coupled to a second gain chip of the at least two gain chips, a first wavelength selective photonic ring resonator optically coupled to the first waveguide, a second wavelength selective photonic ring resonator optically coupled to second waveguide, a third waveguide optically coupled to the first waveguide and the second waveguide via the first wavelength selective photonic ring resonator and the second wavelength selective photonic ring resonator. The tunable laser comprising a control circuit configured to apply a first current to the first gain chip, apply a second current to the second gain chip of the at least two gain chips, and tune the first wavelength selective photonic ring resonator and the second wavelength selective photonic ring resonator to a target wavelength, and cause one of the at least two gain chips to generate the light to output from the tunable laser.

In part, in one aspect, the disclosure relates to a tunable laser comprising at least two gain chips configured to generate light and a wavelength selection circuit comprising an optical switch. The optical switch comprising a first waveguide coupled to a first gain chip of the at least two gain chips, a second waveguide coupled to a second gain chip of the at least two gain chips, a first wavelength selective photonic ring resonator optically coupled to the first waveguide, and a second wavelength selective photonic ring resonator optically coupled to second waveguide. The optical switch comprising a partial reflector coupled to the optical switch. The tunable laser comprising a control circuit configured to apply a first current to the first gain chip to bias the first gain chip, wherein biasing the first gain chip to provide an optical output power, tune the first wavelength selective photonic ring resonator to a target wavelength, and output light through the partial reflector.

### EXAMPLE EMBODIMENTS

This disclosure is directed to Wavelength Division Multiplexing (WDM) coherent communications. For example, in coherent communications employing coherent transceivers, widely tunable lasers are often used with a tuning range of greater than 45nm in C-band, a high optical power of greater than 16 dBm, a low linewidth of less than 100 kHz, and a high accuracy of optical wavelength within +/- 1.5 GHz. C-band widely tunable lasers in with these demanding features have been realized with external cavity laser consists of free-space wavelength-selective elements, photonic integrated circuit (PIC), or integrated sampled grating distributed Bragg reflector (SGDBR). L-band or S-band widely tunable lasers can also be achieved using the same technologies.

However, it is challenging to make a C+L, or S+C, or S+C+L band widely tunable laser, since the gain spectrum of a conventional gain chip has a limited gain bandwidth. The other challenge with a widely tunable laser, for example a C-band widely tunable laser, is that the laser needs a power-hungry thermo-electrical controlled laser to hold the laser temperature, to overcome gain spectrum shift with temperature which makes wide tuning (e.g. covering C-band) at different temperatures impossible.

In this disclosure, solutions are proposed to overcome these challenges and provide a widely tunable laser. The proposed lasers have a wide tuning range by employing two or more gain mediums (from two or more different dies or from the same die) with different peak gain wavelengths, and shared wavelength selective elements in an external cavity laser configuration.

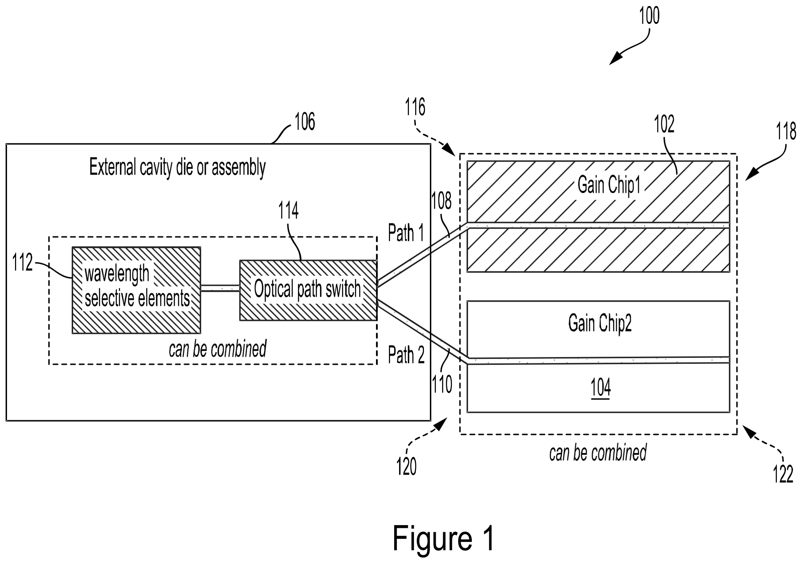

Figure 1 illustrates a block diagram of a laser configuration, according to an embodiment of the present disclosure. The laser 100 may include a first gain chip 102 and a second gain chip 104. The first gain chip 102 and the second gain chip 104 are configured to generate light. The first gain chip 102 and second gain chip 104 may have different peak gain wavelengths corresponding to their different gain medium designs, e.g., C-band, L-band, and/or S-band peak wavelengths. The first gain chip 102 and the second gain chip 104 can be two separate dies with different gain mediums, or they can be two different gain mediums grown on the same III-V substrate, achieved by selective etch/regrowth epitaxy techniques.

The first gain chip 102 may be coupled to a first optical path 108 that extends from a first end 116 of the gain chip to a second end 118 of the gain chip. The second gain chip 104 may be coupled to the second optical path 110 that extends through a first end 120 of the gain chip to a second end 122 of the gain chip. The first end 116,120 is coupled to the external die 106.

The optical waveguides 108, 110 may both be optically coupled to a shared external cavity section 106 for laser wavelength selection. The external cavity section 106 may include an optical switch 114 to choose the optical connections to the first gain chip 102, the second gain chip 104, or both. The external cavity section 106 may also comprise a wavelength selective die or component 112.

In one embodiment, the external cavity section 106 can comprise discrete optical components. In another embodiment, the external cavity section 106 may comprise a semiconductor chip, e.g., a photonic integrated circuit (PIC) with integrated optical components made through semiconductor fabrication technology.

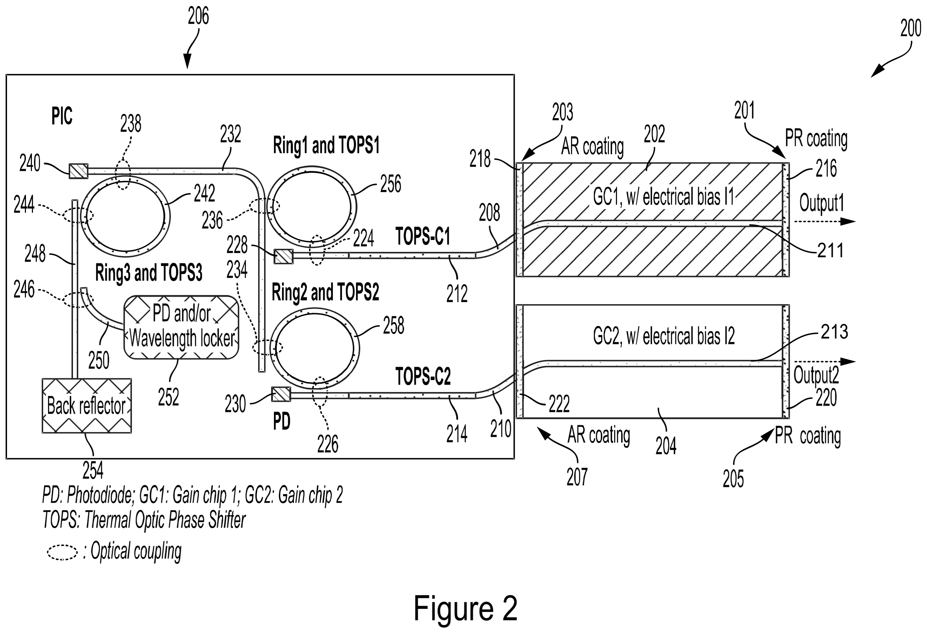

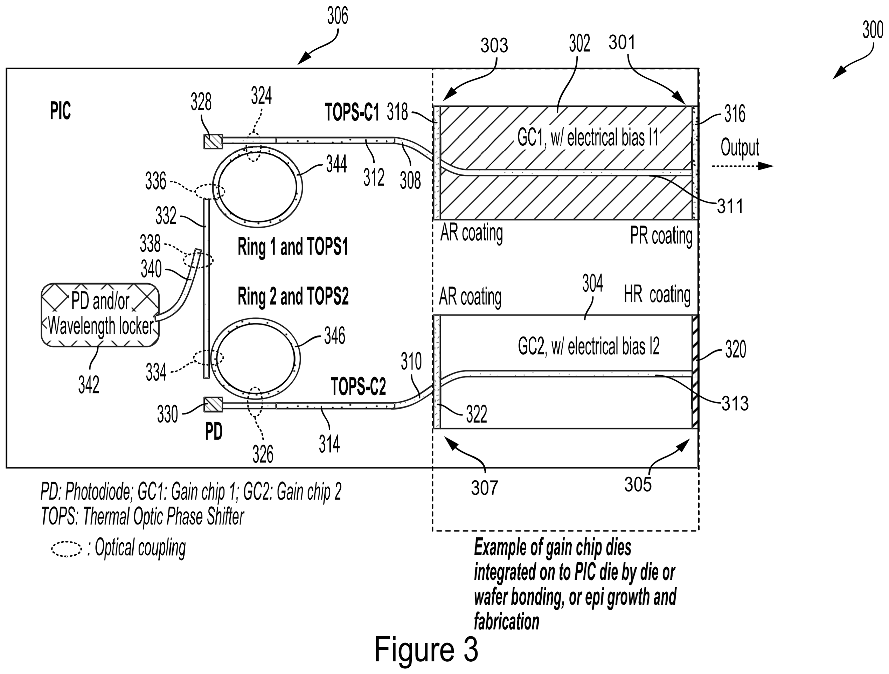

The laser 100 of Figure 1 illustrates a general block diagram of the embodiments shown in Figures 2 and 3.

Figure 2 is an example of a tunable laser configuration, according to an embodiment of the present disclosure. The tunable laser 200 comprises at least two gain chips configured to generate light, a wavelength selection circuit 206, and a control circuit to control the output of the tunable laser 200. The laser 200 is configured to output light from the partially reflective coating of either the first gain chip or the second gain chip, depending on which chip is selected.

For example, the tunable laser 200 may comprise a first gain chip 202 and a second gain chip 204. The first gain chip 202 and the second gain chip 204 may be configured for different wavelengths, e.g., the first gain chip 202 may be configured for C-band and the second gain chip 204 may be configured for an L-band. The gain chips may have different peak gain wavelengths.

The first gain chip 202 comprises a first reflective coating 216 at a first end 201 of the gain chip 202 and a second reflective coating 218 at a second end 203 of the gain chip 202. The first reflective 216 coating may be a partially reflective coating. The second reflective coating 218 may be an anti-reflective coating. The first end 201 of the first gain chip 202 is configured to output light from the laser 200.

The second gain chip 204 comprises a first reflective coating 220 at a first end 205 of the gain chip 204 and a second reflective coating 220 at a second end 207 of the gain chip 204. The first reflective coating 220 may be a partially reflective coating. The second reflective coating 222 may be an anti-reflective coating. The first end 205 of the second gain chip 204 is configured to output light from the laser 200.

The first gain chip 202 comprises a waveguide 211, which extends from the first end 201 of the first gain chip 202 to the second end 203 of the first gain chip 202, and this waveguide 211 is optically coupled to a first external-cavity optical waveguide 208 which is connected to a first optional photodetector 228 on the wavelength selective circuit 206.

The second gain chip 204 comprises a waveguide 213, which extends from the first end 205 of the second gain chip 204 to the second end 207 of the second gain chip 204, and this waveguide 213 is optically coupled to a second external-cavity optical waveguide 210 which is connected to a second optional photodetector 230 on the wavelength selective circuit 206.

The wavelength selective circuit 206 may be a PIC. The wavelength selective circuit 206 includes the first waveguide 208 coupled to the first gain chip 202 of the at least two gain chips and the second waveguide 210 coupled to the second gain chip 204 of the at least two gain chips. The wavelength selective circuit 206 is configured to select a wavelength to output from the laser.

The wavelength selective circuit 206 may also include a first wavelength selective photonic ring resonator (first ring) 256 optically coupled to the first waveguide 208 and a second wavelength selective photonic ring resonator (second ring) 258 optically coupled to the second waveguide 210. The optical coupling of the first waveguide 208 and the first ring 256 is shown by the circle 224. The optical coupling of the second waveguide 210 and the second ring 258 is shown by the circle 226.

Each ring resonator can select a set of wavelengths, i.e., resonant wavelengths, with equal wavelength spacing, i.e., free spectrum range (FSR), which is determined by ring radius and material. By using multiple rings with different radii or materials, thus different FSRs, the ring resonators can be configured to select a common wavelength by being thermally or electrically tuned to align at the target wavelength. Due to the Vernier effect, only the target wavelength is allowed to lase in the cavity.

At the end of the first waveguide 208 in the wavelength selective circuit is a first photodetector 228. The photodetector monitors the residual light power at this through port of the first waveguide 208, and the resulted photodetector current can be used as a measurement of wavelength alignment between the ring resonance and lasing mode.

At the end of the second waveguide 210 in the wavelength selective circuit is a second photodetector 230. The photodetector monitors the residual light power at this through port of the second waveguide 210, and the resulted photodetector current can be used as a measurement of wavelength alignment between the ring resonance and lasing mode.

A third waveguide 232 is optically coupled to the first ring resonator 256 and the second ring resonator 258. The third waveguide 232 is optically coupled to the first ring 256 as shown by circle 236. The third waveguide is optically coupled to the second ring 258 as shown by circle 234.

The third waveguide 232 may be optically coupled to a third ring resonator 242 at circle 238 and optically coupled a fourth 248 and fifth 250 waveguide. The third ring 242 couples the third waveguide 232 to the fourth waveguide 248 as shown by circle 244. The fourth waveguide 248 may be optically coupled to the fifth waveguide 250 as shown in circle 246. The fourth waveguide 248 is coupled to a back reflector 254. The fifth waveguide 250 may be optically coupled to or connected to at least one of a photodetector or a wavelength locker 252.

The third ring 242 may have a different free spectral range (FSR) from the first ring 256 and the second ring 258, while the first ring 256 and the second ring 258 can have the same or different FSRs.

The first 208 and second 210 waveguides may comprise thermal optical shifters (TOPS). The TOPS are formed on the first 208 and second 210 waveguides in the wavelength selection circuit 206. The TOPS are configured to adjust the cavity phase to match the lasing wavelength. The first waveguide comprises TOPS-C1 212, and the second waveguide comprises TOPS-C2 214. The first 256, second 258, and third 242 ring resonators may comprise TOPS. To adjust the TOPS a current is sent to the rings to change the temperature of the TOPS. Changing the temperature of the TOPS adjust the cavity phase to change the wavelength.

The control circuit is configured to control the laser 200. The control circuit is configured to apply a first current to the first gain chip 202 to bias the first gain chip 202. The bias to the first gain chip 202 provides a desired optical output power. The control circuit may tune the first wavelength selective filter to a target wavelength and tune the third wavelength selective filter to the target wavelength. The control circuit may bias the second gain chip differently while biasing the first gain chip. The control circuit may tune the second wavelength selective ring resonator off-resonance

For example, for operating in the band of the first gain chip 202, the control circuit biases the first gain chip 202 and the second gain chip 204. The bias current to the second gain chip is zero. The first 256 and third 242 ring are tuned to the target wavelength by adjusting the bias of the TOPS on the first and third rings. This changes the temperature of rings, thus changing the optical refractive indexes and resonant wavelengths of the rings. The TOPS on the waveguide adjusts the cavity phase to match the lasing wavelength. In some embodiments, the second ring can be tuned off-resonance of the selected wavelength to prevent light leakage by the second gain chip 204.

For example, for operating in the band of the second gain chip 204, the second gain chip 204 is be biased with a high current and the first gain chip is biased with no current. Also, the TOPS on the second 258 and third 242 rings are tuned to the desired output wavelength.

Figure 3 is an example laser configuration, according to an embodiment of the present disclosure. The tunable laser 300 comprises at least two gain chips configured to generate light, a wavelength selection circuit 306, and a control circuit to control the output of the tunable laser. The laser 300 is configured to output light from the partially reflective coating of either the first gain chip or the second gain chip, depending on which chip is comprises the partially reflective coating. In this example, the first gain chip comprises the partially reflective coating. One gain chip of the at least two gain chips has a partially reflective coating to provide an output port, while the other gain chips of the at least two gain chips terminate the laser output by employing highly reflective coatings.

The first 302 and second gain chip 304 may be grown on a common substrate with the wavelength selective circuit. For example, the gain chips 302, 304 may be integrated with the PIC by die or wafer bonding, or selective epitaxy growth on the same substrate as PIC, followed by semiconductor fabrication process.

The first gain chip 302 and the second gain chip 304 may be configured for different wavelengths, e.g., the first gain chip 302 may be configured for C-band and the second gain chip 304 may be configured for an L-band. The gain chips 302, 304 may have different peak gain wavelengths.

The first gain chip 302 comprises a first reflective coating 316 at a first end 301 of the gain chip 302 and a second reflective coating 318 at a second end 303 of the gain chip 302. The first reflective 316 coating may be a partially reflective coating. The second reflective coating 318 may be an anti-reflective coating. The first end 301 of the first gain chip 302 is configured to output light from the laser 300 in the embodiment shown.

The second gain chip 304 comprises a first reflective coating 320 at a first end 305 of the gain chip 304 and a second reflective coating 322 at a second end 307 of the gain chip 304. The first reflective coating 320 may be a highly reflective coating. The second reflective coating 322 may be an anti-reflective coating.

The first gain chip 302 comprises a waveguide 311, which extends from the first end 301 of the first gain chip 302 to the second end 303 of the first gain chip 302, and this waveguide 311 is optically coupled to a first external-cavity optical waveguide 308 which is connected to a first optional photodetector 328 on the wavelength selective circuit 306.

The second gain chip 304 comprises a waveguide 313, which extends from the first end 305 of the second gain chip 304 to the second end 307 of the second gain chip 304, and this waveguide 313 is optically coupled to a second external-cavity optical waveguide 310 which is connected to a second optional photodetector 330 on the wavelength selective circuit 306.

The wavelength selective circuit 306 may be a PIC. The wavelength selective circuit 306 includes the first waveguide 308 coupled to the first gain chip 302 of the at least two gain chips and the second waveguide 310 coupled to the second gain chip 304 of the at least two gain chips. The wavelength selective circuit 306 is configured to select a wavelength.

The wavelength selective circuit 306 may also include a first wavelength selective photonic ring resonator (first ring) 344 optically coupled to the first waveguide 308 and a second wavelength selective photonic ring resonator (second ring) 346 optically coupled to the second waveguide 310. The optical coupling of the first waveguide 308 and the first ring 344 is shown by the circle 324. The optical coupling of the second waveguide 310 and the second ring 346 is shown by the circle 326.

The first ring 344 is optically coupled to the second ring by a third waveguide 332. The first ring 344 is optically coupled to the third waveguide 332 at circle 336 and the second ring 346 is optically coupled to the third waveguide 332 at circle 334. Each ring resonator can select a set of wavelengths, i.e., resonant wavelengths, with equal wavelength spacing, i.e., free spectrum range (FSR), which is determined by ring radius and material. By using two or more rings with different radii or materials, thus different FSRs, the ring resonators can be configured to select a common wavelength by being thermally or electrically tuned to align at the target wavelength. Due to the Vernier effect, only the target wavelength is allowed to lase in the cavity.

A fourth waveguide 340 may be optically coupled to the third waveguide 332 at circle 338. A photodiode or wavelength locker 342 is coupled at the end of the fifth waveguide. At the end of the first waveguide in the wavelength selective circuit is a first photodetector 328. The photodetector monitors the residual light power at this through port of the first waveguide, and the resulted photodetector current can be used as a measurement of wavelength alignment between the ring resonance and lasing mode. At the end of the first waveguide 308 in the wavelength selective circuit is a first photodetector 328. At the end of the second waveguide 310 in the wavelength selective circuit is a second photodetector 330. The photodetectors 328, 330 monitors the residual light power at this through port of the first waveguide, and the resulted photodetector current can be used as a measurement of wavelength alignment between the ring resonance and lasing mode.

The laser 300 comprises an output port through the partially reflective facet. The laser output from the gain chip facet with the partially reflective coating.

The control circuit is configured to control the laser. The control circuit is configured to adjust the bias current applied to the first 302 and second 304 gain chip to choose which chip to bias. The control circuit may apply a first current to the first gain chip 302 and apply a second current to the second gain chip 304. The control circuit may tune the first wavelength selective filter and the second wavelength selective filter to a target wavelength to cause one of the at least two gain chips to generate the light to output from the tunable laser. The first wavelength selective filter may be the first ring resonator 344 and the second wavelength selective filter may be the second ring resonator 346.

For example, in biasing the first gain chip 302, a current is applied to the first gain chip to provide a desired optical output power. A second current is applied to the second gain chip 304. The second current may be a low bias current. The second bias current may be greater than zero. The second current can be a low bias equal to the current of the second gain chip 304 where the net gain is zero or it can be a current to provide some gain for the target wavelength, though the target wavelength does not match the peak gain wavelength of the second gain chip 304. The first ring 344 and the second ring 346 are tuned to the target wavelength.

For outputting light in the band of the second gain chip 304 (for example L-band or S-band operation), the procedure is similar to above, but the current to the second gain chip 304 is the dominant bias (e.g., a high current) and provides desirable optical output power. The current to the first gain chip can be around or above transparent current, to eliminate loss from the first gain chip 302, or it can still provide some gain for the target wavelength.

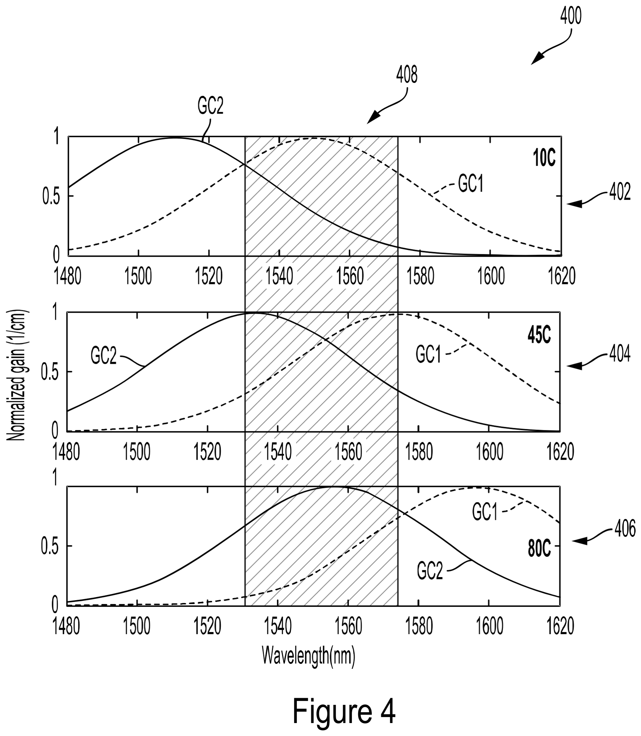

Furthermore, the configuration of the laser 300 shown in Figure 3 can also be used for thermo-electric cooler free widely tunable laser. For example, Figure 4 illustrates the gain spectrum of the first gain chip 302 and the second gain chip 304 at different temperatures and wavelengths. In this embodiment, the first gain chip 302 wavelength is longer than that of the second gain chip 304 wavelength. The first and second gain chip have different peak gain wavelengths, which also change with the ambient temperatures.

For example, as shown in plot 402, at lower temperatures (e.g., ~10C), both the first gain chip 302 (GC1) and the second gain chip 304 (GC2) have gain shifted to shorter wavelengths. GC1 should be chosen as the dominant chip with a high current bias since its gain is higher than GC2.

For example, as shown in plot 404, at medium temperatures (e.g., ~45C), GC1 and GC2 have comparable gain in the target tuning range 408, so both chips can be biased with comparable current, to achieve optimal efficiency.

For example, as shown in plot 406, at high temperatures, e.g., ~ 80C, GC2 has higher gain and is chosen as the dominant chip with high current bias.

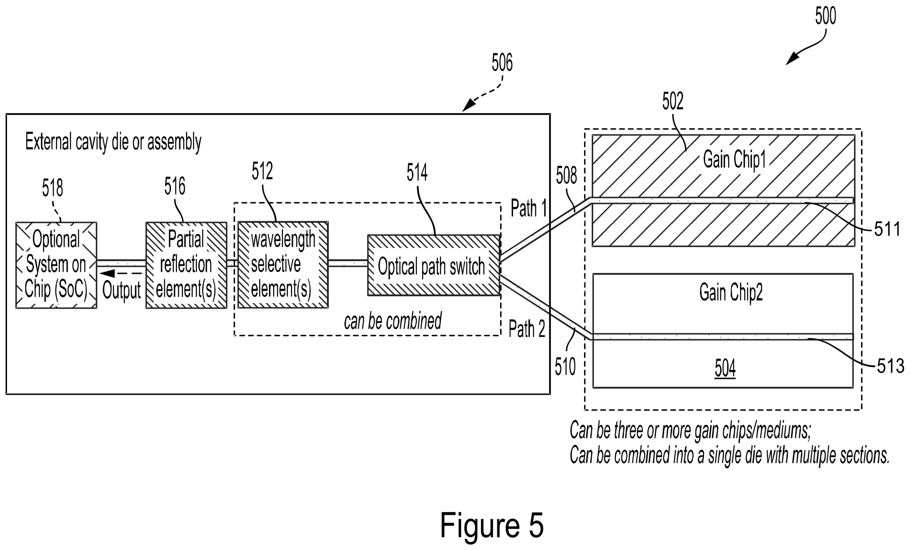

Figure 5 is a general block diagram of a tunable laser to output laser power from the external cavity side, according to an embodiment of the present disclosure. The tunable laser 500 comprises at least two gain chips configured to generate light, a wavelength selection circuit 512, and a control circuit to control the output of the tunable laser. The laser 500 is configured to output laser power from the external cavity side.

The first gain chip 502 and the second gain chip 504 may have different peak gain wavelengths corresponding to their different gain medium designs, e.g. C-band, L-band, and/or S-band peak wavelengths. The first gain chip 502 and the second gain chip 504 can be two separate dies with different gain mediums, or they can be two different gain mediums grown on the same III-V substrate, achieved by selective etch/regrowth epitaxy techniques.

The first gain chip 502 comprises a waveguide 511, which extends from the first end of the first gain chip 502 to the second end of the first gain chip 502, and this waveguide 511 is optically coupled to a first optical path 508.

The second gain chip 504 comprises a waveguide 513, which extends from the first end of the second gain chip 504 to the second end of the second gain chip 504, and this waveguide 513 is optically coupled to a second path 510.

The first gain chip 502 may be coupled to a first optical path 508 and the second gain chip 504 may be coupled to the second optical path 510. The optical paths 508, 510 may both be optically coupled to a shared external cavity die 506 for laser wavelength selection. The external cavity section 506 may include an optical switch 514 to choose the optical connections to the first gain chip 502, the second gain chip 504, or both. The external cavity section 506 may also comprise a wavelength selective element 512. In some embodiments, the optical path switch 514 and the wavelength selective elements 512 can be combined.

In one embodiment, the external cavity section 506 can comprise discrete optical components. In another embodiment, the external cavity section 506 may comprise a semiconductor chip, e.g., a photonic integrated circuit (PIC) with integrated optical components made through semiconductor fabrication technology. The external cavity section may be wavelength selective circuit.

The external cavity section 506 may also comprise partially reflective elements 516. Optionally, the external cavity section 506 may comprise optional system on chip 518.

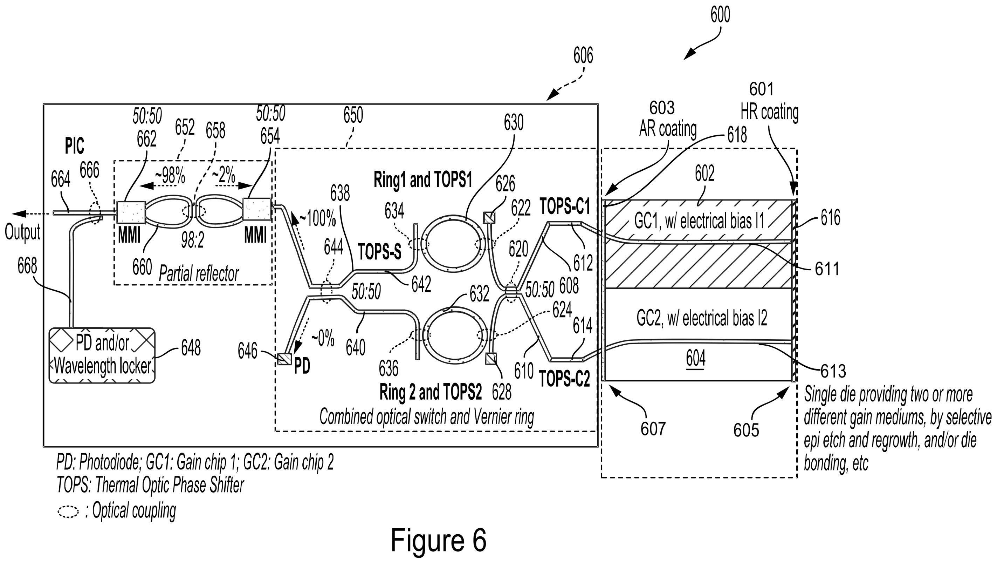

Figure 6 is a tunable laser configuration, according to an embodiment of the present disclosure. The laser 600 has an output port at the PIC side. The tunable laser 600 comprises at least two gain chips configured to generate light, a wavelength selection circuit 650, and a control circuit to control the output of the tunable laser 600.

For example, the tunable laser 600 may comprise a first gain chip 602 and a second gain chip 604. The first gain chip 602 and the second gain chip 604 may be configured for different wavelengths, e.g., the first gain chip 602 may be configured for C-band and the second gain chip 604 may be configured for an L-band. The gain chips may have different peak gain wavelengths.

The first gain chip 602 comprises a first reflective coating 616 at a first end 601 of the gain chip 602 and a second reflective coating 618 at a second end 603 of the gain chip 602. The first reflective 616 coating may be a highly reflective coating. The second reflective coating 618 may be an anti-reflective coating.

The second gain chip 604 comprises the first reflective coating 616 at a first end 605 of the gain chip 604 and the second reflective coating 618 at a second end 607 of the gain chip 604.

The first gain chip 602 comprises a waveguide 611, which extends from the first end 601 of the first gain chip 602 to the second end 603 of the first gain chip 602, and this waveguide 611 is optically coupled to a first external-cavity optical waveguide 608 which is connected to a first optional photodetector 626 on the wavelength selective circuit 650.

The second gain chip 604 comprises a waveguide 613, which extends from the first end 605 of the second gain chip 604 to the second end 607 of the second gain chip 604, and this waveguide 613 is optically coupled to a second external-cavity optical waveguide 610 which is connected to a second optional photodetector 628 on the wavelength selective circuit 650.

The wavelength selective circuit 650 may be integrated on an external cavity 606. The external cavity 606 maybe a PIC. The wavelength selective circuit 650 includes the first waveguide 608 coupled to the first gain chip 602 of the at least two gain chips and the second waveguide 610 coupled to the second gain chip 604 of the at least two gain chips. The wavelength selective circuit 650 is configured to select a wavelength.

The wavelength selective circuit 650 may also include a first wavelength selective photonic ring resonator (first ring) 630 optically coupled to the first waveguide 608 and a second wavelength selective photonic ring resonator (second ring) 632 optically coupled to the second waveguide 610. The optical coupling of the first waveguide 608 and the first ring 630 is shown by the circle 622. The optical coupling of the second waveguide 610 and the second ring 632 is shown by the circle 624.

Each ring resonator 630, 632 can select a set of wavelengths, i.e., resonant wavelengths, with equal wavelength spacing, i.e., free spectrum range (FSR), which is determined by ring radius and material. By using multiple rings with different radii or materials, thus different FSRs, the ring resonators can be configured to select a common wavelength by being thermally or electrically tuned to align at the target wavelength. Due to the Vernier effect, only the target wavelength is allowed to lase in the cavity.

At the end of the first waveguide 610 in the wavelength selective circuit may be a first photodetector 626. The photodetector 626 monitors the residual light power at this through port of the first waveguide 608, and the resulted photodetector current is used as a measurement of wavelength alignment between the ring resonance and lasing mode.

At the end of the second waveguide in the wavelength selective circuit may be a second photodetector 628. The photodetector 628 monitors the residual light power at this through port of the second waveguide 610, and the resulted photodetector current is used as a measurement of wavelength alignment between the ring resonance and lasing mode.

The first and second waveguide are optically coupled together at circle 620. The optical coupling at circle 620 may form a 50:50 coupler.

A third waveguide 638 is optically coupled to the first ring resonator 630. The third waveguide 638 is optically coupled to the first ring 630 as shown by circle 634. A fourth waveguide 640 is optically coupled to the second ring resonator 632. The fourth waveguide 640 is optically coupled to the second ring 632 as shown by circle 636.

The third 638 and fourth 640 waveguides are optically coupled together, as shown at circle 644. The optical coupling at circle 644 may form a 50:50 coupler. At the end of the fourth waveguide may be an optional photodetector 646. The third waveguide is part of a partial reflector 652.

The third waveguide 638 is optically coupled to the fifth waveguide 660 as shown in circle 658. The third and fifth waveguides form a partial reflector such that a percentage of the light is reflected back to the 650. The remaining portion of the light is output through the fifth waveguide 660 to a sixth waveguide 664. The third and fifth waveguides form a partial reflector by forming a loop with the waveguides. The third waveguide is looped back to via a multimode interferometer (MMI) 654. The fifth waveguide 660 is looped back via MMI 662. The percentage of light reflected back may vary based on the loop of the third and fifth waveguides, e.g., 2% reflected back to the wavelength selective circuit. The MMI 654, 662 may reflect a portion of the light back, e.g., 50%.

The first 608 and second 610 waveguides may comprise thermal optical shifters (TOPS). The thermal optical waveguide shifters are formed on the first 608 and second 610 waveguides in the wavelength selection circuit 650. The TOPS are configured to adjust the cavity phase to match the lasing wavelength. The first waveguide 608 may comprise TOPS-C1 612. The second waveguide 610 may comprise TOPS-C1 614.

The control circuit is configured to control the laser. The control circuit is configured to apply a first current to the first gain chip 602 to bias the first gain chip 602. The bias to the first gain chip provides a desired optical output power. The control circuit is configured to tune the first wavelength selective filter to a target wavelength and tune the second wavelength selective filter to the target wavelength. The wavelength selective filters may be the optical ring resonators.

The control circuit may be configured to bias the second gain chip in a similar manner to biasing the first gain chip.

For example, for operating in the band of the first gain chip, the control circuit biases the first gain chip and the second gain chip. The bias current to the second gain chip is zero. The first and second ring are tuned to the target wavelength by adjusting the bias of the TOPS on the first and second rings. This changes the temperature of rings, thus changing the optical refractive indexes and resonant wavelengths of the rings. The TOPS on the waveguide adjusts the cavity phase to match the lasing wavelength.

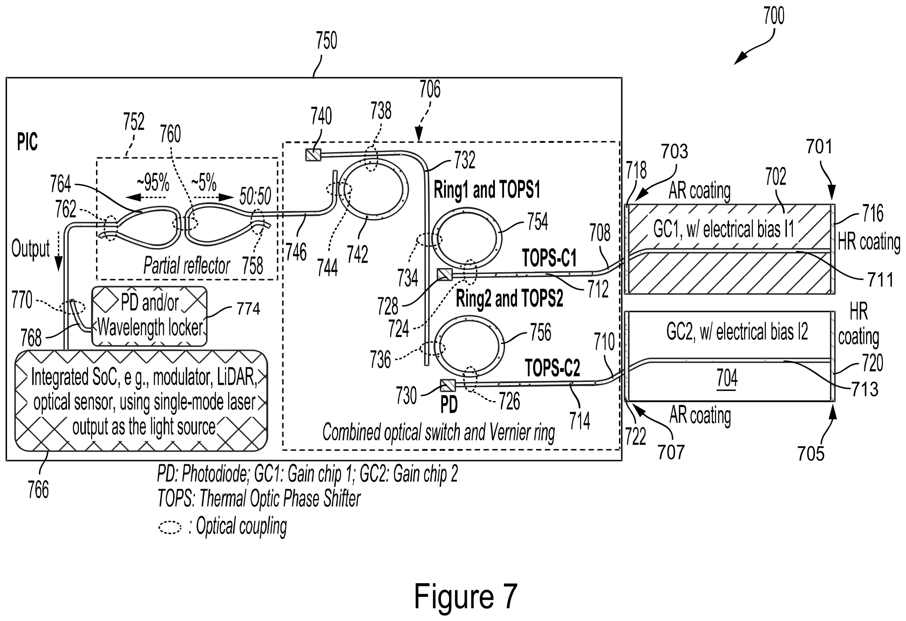

The laser may be directly coupled into a system-on-a-chip (SoC), as shown in Figure 7, which uses the laser output as the light source. The SoC examples include but not limited to modulators, LiDAR, optical sensing, photonic computing, etc.

The partial reflector for laser output/reflection may be MMI loops as shown in Figure 6, or Sagnac loops as shown in Figure 7.

The laser 600 may employ a Mach-Zehnder Interferometer (MZI) configuration to switch optical connections between PIC and the two gain chips. To make the structure compact, the two optical rings 630, 632 are integrated inside the MZI structure. Switching between the two gain chips 602, 604, as well as the corresponding optical paths, is achieved by adjusting the bias applied on TOPS_S 642 to change the relative phase difference between the two MZ arms, e.g., optical waveguide 608, 610. When GC2 is selected, TOPS_S is biased to achieve a 0-phase difference between two MZ arms. When GC1 is selected, TOPS_S is biased to achieve Pi phase difference between two MZ arms. The un-selected gain chip has zero bias.

The output from the wavelength selective circuit 650 is via a partial reflector 652 on the PIC, with a portion of light, e.g., 1~5%, reflected back into the laser cavity. This partial reflector used as an example here is based on two optically coupled loops formed by two multimode interferometers (MMIs), providing 98% output and 2% reflection, although any values may be used.

In this example shown in Figure 6, another optional feature included as an example is that the different gain mediums GC1 and GC2 are from a single die, by selective epitaxy etch and regrowth, or die/wafer bonding techniques.

Shown in Figure 7 is a fourth example of the proposed laser configuration, in which the laser output is at the PIC. The laser 700 has an output in which the laser output is at the PIC side. The tunable laser 700 comprises at least two gain chips configured to generate light, a wavelength selection circuit 706, and a control circuit to control the output of the tunable laser 700.

For example, the tunable laser 700 may comprise a first gain chip 702 and a second gain chip 704. The first gain chip 702 and the second gain chip 704 may be configured for different wavelengths, e.g., the first gain chip 702 may be configured for C-band and the second gain chip 704 may be configured for an L-band. The gain chips may have different peak gain wavelengths.

The first gain chip 702 comprises a first reflective coating 716 at a first end 701 of the gain chip 702 and a second reflective coating 718 at a second end 703 of the gain chip 702. The first reflective 716 coating may be a highly reflective coating. The second reflective coating 718 may be an anti-reflective coating.

The second gain chip 704 comprises a first reflective coating 720 at a first end 705 of the gain chip 704 and a second reflective coating 722 at a second end 707 of the gain chip 704. The first reflective coating 720 may be a highly reflective coating. The second reflective coating 722 may be an anti-reflective coating.

The first gain chip 702 comprises a waveguide 711, which extends from the first end 701 of the first gain chip 702 to the second end 703 of the first gain chip 702, and this waveguide 711 is optically coupled to a first external-cavity optical waveguide 708 which is connected to a first optional photodetector 728 on the wavelength selective circuit 706.

The second gain chip 704 comprises a waveguide 713, which extends from the first end 705 of the second gain chip 704 to the second end 707 of the second gain chip 704, and this waveguide 713 is optically coupled to a second external-cavity optical waveguide 710 which is connected to a second optional photodetector 730 on the wavelength selective circuit 706.

The wavelength selective circuit 706 may be integrated on a PIC 750. The wavelength selective circuit 706 includes the first waveguide 708 coupled to the first gain chip 702 of the at least two gain chips and the second waveguide 710 coupled to the second gain chip 704 of the at least two gain chips. The wavelength selective circuit 706 is configured to select a wavelength.

The wavelength selective circuit 706 may also include a first wavelength selective photonic ring resonator (first ring) 754 optically coupled to the first waveguide 708 and a second wavelength selective photonic ring resonator (second ring) 756 optically coupled to the second waveguide 710. The optical coupling of the first waveguide 708 and the first ring 754 is shown by the circle 724. The optical coupling of the second waveguide 710 and the second ring 756 is shown by the circle 726.

Each ring resonator 754, 756 can select a set of wavelengths, i.e., resonant wavelengths, with equal wavelength spacing, i.e., free spectrum range (FSR), which is determined by ring radius and material, to the third waveguide 732. By using multiple rings with different radii or materials, thus different FSRs, the ring resonators can be configured to select a common wavelength by being thermally or electrically tuned to align at the target wavelength. Due to the Vernier effect, only the target wavelength is allowed to lase in the cavity.

At the end of the first waveguide in the wavelength selective circuit is a first photodetector 728. The photodetector monitors the residual light power at this through port of the first waveguide, and the resulted photodetector current is used as a measurement of wavelength alignment between the ring resonance and lasing mode.

At the end of the second waveguide in the wavelength selective circuit is a second photodetector 730. The photodetector monitors the residual light power at this through port of the second waveguide, and the resulted photodetector current is used as a measurement of wavelength alignment between the ring resonance and lasing mode.

A third waveguide 732 is optically coupled to the first ring resonator 754 and the second ring resonator 756. The third waveguide 732 is optically coupled to the first ring 754 as shown by circle 734. The third waveguide 732 is optically coupled to the second ring 756 as shown by circle 736.

The third waveguide 732 may be optically coupled to a third ring 742, and the third ring 742 may be optically coupled to a fourth waveguide 746. The third ring 742 couples to the fourth waveguide 746 as shown by circle 744.

The fourth waveguide 746 is optically coupled to the fifth waveguide 764 as shown in circle 760. The fifth waveguide 764 can be coupled to at least one of a photodiode or wavelength locker 774 via a sixth waveguide 768 and optically coupled as shown by circle 770. The fifth waveguide may also be coupled to an integrated system on chip 766, e.g., a modulator, LiDar, optical sensor, with asignle-0mode laser output as the light source.

The fourth 746 and fifth 764 waveguides form a partial reflector 752 such that a percentage of the light is reflected back to the wavelength selective circuit 706. The remaining portion of the light is output through the fifth waveguide 764.

The fourth 746 and fifth 764 waveguides may form a partial reflector by forming two optically coupled Sagnac loops with the waveguides. The fourth waveguide 746 is looped back to optical coupling at circle 758 with the fourth waveguide 746. The optical coupling at circle 758 may form a 50:50 coupler. The fifth waveguide 764 is looped back to optical coupling at circle 762 with the fifth waveguide 764.

The third ring 742 may have a different free spectral range (FSR) from the first ring 754 and the second ring 756, while the first ring 754 and the second ring 756 can have the same or different FSRs.

The first 708 and second 710 waveguides may comprise thermal optical shifters (TOPS). The thermal optical waveguide shifters are formed on or in the vicinity of the first 708 and second 710 waveguides in the wavelength selection circuit 706. The TOPS are configured to adjust the cavity phase to match the lasing wavelength. The first waveguide 708 may comprise TOPS-C1 712. The second waveguide 710 may comprise TOPS-C1 714.

The control circuit is configured to control the laser. The control circuit is configured to apply a first current to the first gain chip 702 to bias the first gain chip 702. The bias to the first gain chip 702 provides a desired optical output power. The control circuit is configured to tune the first wavelength selective filter to a target wavelength and tune the third wavelength selective filter to the target wavelength. The wavelength selective filters may be the optical ring resonators.

The control circuit may be configured to bias the second gain chip 704 in a similar manner to biasing the first gain chip 702.

For example, for operating in the band of the first gain chip 702, the control circuit biases the first gain chip 702 and the second gain chip 704. The bias current to the second gain chip is zero. The first 754 and third 742 ring are tuned to the target wavelength by adjusting the bias of the TOPS on the first 754 and third 742 rings. This changes the temperature of rings, thus changing the optical refractive indexes and resonant wavelengths of the rings. The TOPS on the waveguide adjusts the cavity phase to match the lasing wavelength. In some embodiments, the second ring 756 can be tuned off-resonance of the selected wavelength to prevent light leakage into the second gain chip 704.

The laser may be directly coupled into a system-on-a-chip (SoC) which uses the laser output as the light source. The SoC examples include but not limited to modulators, LiDAR, optical sensing, photonic computing, etc.

The partial reflector for laser output/reflection used in this example is similar to the previous one in Figure 6, both based on optically coupled loops. However, here 50:50 couplers are used to form the Sagnac loops.

Having thus described several aspects and embodiments of the technology of this application, it is to be appreciated that various alterations, modifications, and improvements will readily occur to those of ordinary skill in the art. Such alterations, modifications, and improvements are intended to be within the scope of the technology described in the application. It is, therefore, to be understood that the foregoing embodiments are presented by way of example only and that, within the scope of the appended claims and equivalents thereto, inventive embodiments may be practiced otherwise than as specifically described. In addition, any combination of two or more features, systems, articles, materials, and/or methods described herein, if such features, systems, articles, materials, and/or methods are not mutually inconsistent, is included within the scope of the present disclosure.

In some embodiments, a device controller may be any type of controller. In certain embodiments, a microprocessor may be a device controller and run a control loop. In other embodiments, an ASIC may be a device controller and may run a control loop. In further embodiments, a device controller may be an analog circuitry. In many embodiments, a bias controller may be a device controller. In certain embodiments, a bias controller may be an analog circuitry.

In some embodiments, one or more of the embodiments described herein may be stored on a computer readable medium. In certain embodiments, a computer readable medium may be one or more memories, one or more hard drives, one or more flash drives, one or more compact disk drives, or any other type of computer readable medium. In certain embodiments, one or more of the embodiments described herein may be embodied in a computer program product that may enable a processor to execute the embodiments. In many embodiments, one or more of the embodiments described herein may be executed on at least a portion of a processor.

In most embodiments, a processor may be a physical or virtual processor. In other embodiments, a virtual processor may be spread across one or more portions of one or more physical processors. In certain embodiments, one or more of the embodiments described herein may be embodied in hardware such as a Digital Signal Processor (DSP). In certain embodiments, one or more of the embodiments herein may be executed on a DSP. One or more of the embodiments herein may be programmed into a DSP. In some embodiments, a DSP may have one or more processors and one or more memories. In certain embodiments, a DSP may have one or more computer readable storages. In many embodiments, a DSP may be a custom designed ASIC chip. In other embodiments, one or more of the embodiments stored on a computer readable medium may be loaded into a processor and executed.

Also, as described, some aspects may be embodied as one or more methods. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

The phrase "and/or" as used herein in the specification and in the claims, should be understood to mean "either or both" of the elements so conjoined, e.g., elements that are conjunctively present in some cases and disjunctively present in other cases.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value.

In the claims, as well as in the specification above, all transitional phrases such as "comprising," "including," "carrying," "having," "containing," "involving," "holding," "composed of," and the like are to be understood to be open-ended, e.g., to mean including but not limited to. The transitional phrases "consisting of" and "consisting essentially of" shall be closed or semi-closed transitional phrases, respectively.

Where a range or list of values is provided, each intervening value between the upper and lower limits of that range or list of values is individually contemplated and is encompassed within the disclosure as if each value were specifically enumerated herein. In addition, smaller ranges between and including the upper and lower limits of a given range are contemplated and encompassed within the disclosure. The listing of exemplary values or ranges is not a disclaimer of other values or ranges between and including the upper and lower limits of a given range.

Embodiments disclosed herein may be embodied as a system, method, or computer program product. Accordingly, embodiments may take the form of an entirely hardware embodiment, an entirely software embodiment (including firmware, resident software, microcode, etc.) or an embodiment combining software and hardware aspects that may all generally be referred to herein as a "circuit," "module," or "system." Furthermore, embodiments may take the form of a computer program product embodied in one or more computer readable medium(s) having computer readable program code embodied thereon.

## Claims

1. A tunable laser comprising:
at least two gain chips configured to generate light, wherein any of the at least two gain chips are configured to output the light generated by the tunable laser;
a wavelength selection circuit comprising:
a first waveguide coupled to a first gain chip of the at least two gain chips;
a second waveguide coupled to a second gain chip of the at least two gain chips;
a first wavelength selective photonic ring resonator optically coupled to the first waveguide;
a second wavelength selective photonic ring resonator optically coupled to second waveguide; and
a third waveguide optically coupled to the first wavelength selective photonic ring resonator and the second wavelength selective photonic ring resonator;
the tunable laser further comprising:
a control circuit configured to:
apply a first current to the first gain chip to bias the first gain chip, wherein biasing the first gain chip to output the light in a first wavelength band;
tune the first wavelength selective photonic ring resonator to a target wavelength; and
tune the second wavelength selective ring resonator off-resonance.

2. The tunable laser of claim 1, the wavelength selection circuit comprising:
a third wavelength selective photonic ring resonator optically coupled to the first and second waveguide; and
a back reflector optically coupled to the third wavelength selective photonic ring resonator, the back reflector to reflect the light through the third waveguide to the first and second gain chips;
wherein the control circuit is to tune the third wavelength selective photonic ring resonator to the target wavelength.

3. The tunable laser of claim 1 or 2, wherein the first gain chip and the second gain chip are configured for different bands of wavelengths,
optionally wherein the first gain chip has an anti-reflective coating a first end and a partially reflective coating on a second end,
further optionally wherein one of the first or second gain chips is configured to output light through the partially reflective coating.

4. The tunable laser of any preceding claim, wherein the first gain chip comprises:
a partially reflective coating to output the light; and
an anti-reflective coating on an end of the first gain chip coupled to the first waveguide; and
wherein the second gain chip comprises:
a highly reflective coating; and
an anti-reflective coating.

5. The tunable laser of any preceding claim, comprising:
a first thermal optical phase shifter (TOPS) is formed around the first waveguide; and
a second TOPS is formed around the second waveguide;
wherein the control circuit is to tune the first and second TOPS by applying a current to the first and second TOPS,
the laser optionally comprising:
a third TOPS formed around the first wavelength selective photonic ring resonator; and
a fourth TOPS formed around the second wavelength selective photonic ring resonator,
wherein the control circuit is to tune the first and second wavelength selective photonic ring resonators by adjusting a current to the third and fourth TOPS to change a temperature of the first and second wavelength selective photonic ring resonators.

6. A tunable laser comprising:
at least two gain chips configured to generate light, wherein a first gain chip of the at least two gain chips is configured to output the light generated by the tunable laser;
a wavelength selection circuit comprising:
a first waveguide coupled to the first gain chip;
a second waveguide coupled to a second gain chip of the at least two gain chips;
a first wavelength selective photonic ring resonator optically coupled to the first waveguide;
a second wavelength selective photonic ring resonator optically coupled to second waveguide; and
a third waveguide optically coupled to the first waveguide and the second waveguide via the first wavelength selective photonic ring resonator and the second wavelength selective photonic ring resonator;
the tunable laser further comprising:
a control circuit configured to:
apply a first current to the first gain chip;
apply a second current to the second gain chip of the at least two gain chips;
tune the first wavelength selective photonic ring resonator and the second wavelength selective photonic ring resonator to a target wavelength; and
cause one of the at least two gain chips to generate the light to output from the tunable laser.

7. The tunable laser of claim 6, wherein the first gain chip comprises:
a partially reflective coating to output the light; and
an anti-reflective coating on an end of the first gain chip coupled to the first waveguide; and
wherein the second gain chip comprises:
a highly reflective coating; and
an anti-reflective coating,
Optionally wherein an output of the tunable laser is through the partially reflective coating of the first gain chip.

8. The tunable laser of claim 6 or 7, comprising:
a first thermal optical phase shifter (TOPS) is formed around the first waveguide; and
a second TOPS is formed around the second waveguide;
wherein the control circuit is to tune the first and second TOPS by applying a current to the first and second TOPS to change a temperature of the first and second wavelength selective photonic ring resonators.

9. The tunable laser of any of claims 6 to 8, wherein the first gain chip is configured for a first band of wavelengths and the second gain chip is configured for a second band of wavelengths, optionally based on the first current being greater than the second current, the tunable laser is configured to output the first band of wavelengths or wherein the first current is smaller than the second current, the tunable laser is configured to output the second band of wavelengths.

10. A tunable laser comprising:
at least two gain chips configured to generate light;
a wavelength selection circuit comprising:
an optical switch comprising:
a first waveguide coupled to a first gain chip of the at least two gain chips;
a second waveguide coupled to a second gain chip of the at least two gain chips;
a first wavelength selective photonic ring resonator optically coupled to the first waveguide;
a second wavelength selective photonic ring resonator optically coupled to second waveguide; and
a partial reflector coupled to the optical switch;
the tunable laser further comprising:
a control circuit configured to:
apply a first current to the first gain chip to bias the first gain chip, wherein biasing the first gain chip to provide an optical output power,
tune the first wavelength selective photonic ring resonator to a target wavelength; and
output light through the partial reflector.

11. The tunable laser of claim 10, wherein the optical switch comprises:
a third waveguide optically coupled to the first wavelength selective photonic ring resonator and the second wavelength selective photonic ring resonator.

12. The tunable laser of claim 10 or 11, wherein the optical switch comprises:
a third waveguide optically coupled to the first waveguide via the first wavelength selective photonic ring resonator; and
a fourth waveguide optically coupled to the second waveguide via the second wavelength selective photonic ring resonator.

13. The tunable laser of any of claims 10 to 12, wherein the partial reflector comprises Sagnac loops.

14. The tunable laser of any of claims 10 to 13, wherein the first gain chip comprises:
a highly reflective coating to output the light; and
an anti-reflective coating on an end of the first gain chip coupled to the first waveguide; and
wherein the second gain chip comprises:
a highly reflective coating; and
an anti-reflective coating.

15. The tunable laser of any of claims 10 to 14, wherein the first wavelength selective photonic ring resonator and the second wavelength selective photonic ring resonator are tuned by adjusting a bias of thermal optic phase shifters of the first wavelength selective photonic ring resonator and the second wavelength selective photonic ring resonator to change a temperature of the first wavelength selective photonic ring resonator and the second wavelength selective photonic ring resonator.
